# FASCICULE DE BREVET EUROPEEN

(11) **EP 2 815 498 B1**
(45) Date de publication et mention de la délivrance du brevet: **20.01.2016**
(21) Numéro de dépôt: 13705750.1
(22) Date de dépôt: 13.02.2013
(51) Int. Cl.: H02N 2/18

(54) **DISPOSITIF DE RECUPERATION ET DE CONVERSION D'ENERGIE THERMIQUE EN ENERGIE ELECTRIQUE**
VORRICHTUNG ZUR RÜCKGEWINNUNG UND UMWANDLUNG VON WÄRMEENERGIE IN ELEKTRISCHE ENERGIE
DEVICE FOR RECOVERING AND CONVERTING HEAT ENERGY INTO ELECTRICAL ENERGY

(30) Priorité: 14.02.2012 FR 1251368
(43) Date de publication de la demande: 24.12.2014
(73) Titulaire: Commissariat à l'Énergie Atomique et aux Énergies Alternatives, 75015 Paris (FR); STMicroelectronics (Crolles 2) SAS, 38920 Crolles (FR)
(72) Inventeur: OLLIER, Emmanuel, F-38000 Grenoble (FR); MONFRAY, Stéphane, F-38320 Eybens (FR); SKOTNICKI, Thomas, F-38920 Crolles-monfort (FR); SOUPREMANIEN, Ulrich, F-38160 Saint Marcellin (FR)
(74) Mandataire: Brevalex
(86) Numéro de dépôt international: PCT/EP2013/052815
(87) Numéro de publication internationale: WO 2013/120869

(56) Documents cités:
- FR-A1- 2 951 874
- US-A1- 2008 202 114

## Description

### DOMAINE TECHNIQUE ET ART ANTÉRIEUR

La présente invention se rapporte à un dispositif de récupération et de conversion d'énergie thermique en énergie électrique en utilisant le changement de phase d'un fluide.

Les circuits électroniques, lors de leur fonctionnement, produisent de la chaleur. Cette chaleur n'est pas utilisée et doit être évacuée afin de ne pas détériorer les circuits. D'autres sources de chaleur sont également présentes dans notre environnement, comme par exemple les canalisations, les échappements, les parois de machines industrielles,..., dont la chaleur dégagée est inutilisée.

Il est envisagé de récupérer cette chaleur pour la convertir en énergie électrique.

Des dispositifs mettant en oeuvre un changement de phase liquide-vapeur ont été proposés.

Par exemple, le document FR 2 951 874 décrit un dispositif comportant un volume clos délimité par une première paroi destinée à être en contact avec un source chaude et une deuxième paroi en regard de la première paroi destinée à être contact avec une source froide, une couche en matériau piézoélectrique suspendue dans le volume clos entre les deux parois, la couche étant traversée par des ouvertures. Un liquide est disposé dans le volume clos. La deuxième paroi est disposée en dessous de la première paroi. Le fonctionnement de ce dispositif est le suivant :
- le liquide s'écoule par gravité à travers les ouvertures en direction de la deuxième paroi. Lorsqu'il entre en contact avec la deuxième paroi, il se vaporise brutalement, ce qui a pour effet de générer une forte surpression et de fortes contraintes mécaniques qui sont transmises à la couche piézoélectrique qui les transforme en signal électrique,
- la vapeur passe à travers les ouvertures dans la couche piézoélectrique en direction de la première paroi, où elle se condense, et
- le liquide s'écoule à nouveau vers la deuxième paroi par gravité et le cycle recommence.

Ce dispositif présente comme inconvénient de nécessiter d'orienter la deuxième paroi en dessous de la première paroi suivant les forces de gravité pour assurer la chute des gouttes condensées.

Il est fait également référence au document US2008202114.

### EXPOSÉ DE L'INVENTION

C'est par conséquent un but de la présente invention d'offrir un dispositif de récupération et de conversion d'énergie thermique en énergie électrique utilisant le changement de phase d'un fluide, ne nécessitant notamment aucune orientation particulière et permettant une grande miniaturisation.

Le but énoncé ci-dessus est atteint par un dispositif de récupération et de conversion d'énergie thermique en énergie électrique comportant une première cavité dont une paroi est destinée à être en contact avec une source chaude, un deuxième cavité dont une paroi est destinée à être en contact avec une source froide, un matériau piézoélectrique disposé dans au moins une des cavités, un canal primaire connectant la première et la deuxième cavité et au moins un canal secondaire connectant la première et la deuxième cavité, la configuration du canal primaire étant telle qu'elle assure une circulation de gouttes de liquides de la deuxième cavité vers la premières cavité.

Dans un premier exemple, le canal primaire peut comporter une surface intérieure présentant un gradient d'énergie de surface orienté de sorte à provoquer le déplacement des gouttes de liquide de la deuxième cavité vers la première cavité. Par exemple, dans le cas où le fluide est de l'eau, la surface comporte des sections d'hydrophobies différentes, les sections étant de moins en moins hydrophobes en direction de la première cavité.

Dans un autre exemple, le canal principal comporte une section de passage croissante en direction de la première cavité et une surface présentant au moins une propriété d'hydrophobie. Avantageusement, la surface peut présenter une hydrophobie décroissante en direction de la première cavité.

En d'autres termes, le dispositif comporte une chambre de condensation et une chambre de vaporisation connectées par un canal assurant le transfert des gouttes de liquide de la chambre de condensation vers la chambre de vaporisation sans utiliser les forces de gravité. Au moins l'une des chambres comporte une membrane en matériau piézoélectrique.

La présente invention a alors pour objet un dispositif de récupération et de conversion d'énergie thermique en énergie électrique comportant au moins une cellule comprenant :
- une première cavité dont au moins une partie d'au moins une paroi est destinée à être en contact avec une source de chaleur,
- une deuxième cavité dont au moins une partie d'au moins une paroi est destinée à être en contact avec une source froide,
- un canal primaire reliant la première cavité et la deuxième cavité destiné à transporter un fluide sous forme de gouttes liquides, le canal primaire comportant des moyens de déplacement assurant le transport de gouttes de fluide liquide de la deuxième cavité vers la première cavité,
- au moins un canal secondaire reliant la première cavité et la deuxième cavité destiné à transporter le fluide sous forme de gaz,
- au moins un matériau piézoélectrique disposé dans au moins l'une des première et deuxième cavités,
- un fluide sous forme liquide et gazeuse confiné dans la cellule,
- des moyens de connexion dudit matériau piézoélectrique à un dispositif de récupération de l'énergie électrique générée par le matériau piézoélectrique.

De manière avantageuse, les moyens de déplacement sont formés par la surface interne du canal primaire présentant un gradient d'énergie de surface orientée de telle sorte que les gouttes de liquide se déplacent de la deuxième cavité vers la première cavité.

Dans un exemple de réalisation, le gradient d'énergie de surface est obtenue par au moins une première et une deuxième section de surface disposées successivement dans cet ordre entre la deuxième cavité et la première cavité, chacune desdites sections présentant des propriétés de mouillabilité vis-à-vis du fluide, la mouillabilité de la deuxième section étant supérieure à celle de la première section. Les propriétés de mouillabilité peuvent être obtenues part une couche d'un matériau présentant lesdites propriétés de mouillabilité et/ou par structuration d'au moins une section de la surface interne.

Par exemple, le canal primaire présente une section de passage croissante de la deuxième cavité vers la première cavité.

Au moins une partie de la surface interne du canal primaire du côté de la deuxième cavité peut présenter des propriétés de faible mouillabilité vis-à-vis du fluide.

Dans un autre exemple de réalisation, les moyens de déplacement sont de type électrostatique, par exemple mettent en oeuvre le phénomène d'électromouillage.

Le canal primaire peut présenter une forme évasée ou comporter au moins deux tronçons successifs présentant des sections de passage différentes, les sections de passage augmentant de la deuxième cavité vers la première cavité.

La section de passage du canal secondaire peut être telle qu'elle empêche le passage de gouttes liquides. La section du canal secondaire est de préférence inférieure à 0,1 fois la longueur capillaire.

Selon une caractéristique additionnelle, le canal secondaire débouche dans la deuxième cavité à proximité d'une extrémité du canal primaire débouchant dans ladite deuxième cavité.

Le dispositif de récupération et de conversion d'énergie thermique en énergie électrique peut avantageusement comporter au moins une première et une deuxième cellules, et un canal de transfert connectant la première cavité de la première cellule à la deuxième cavité de la deuxième cellule et la deuxième cavité de la première cellule à la première cavité de la deuxième cellule.

De préférence, les parois des première et deuxième cavités sont réalisées en un matériau bon conducteur thermique et dans lequel le dispositif comporte un élément extérieur reliant les parois des première et deuxième cavités, ledit élément extérieur étant en matériau isolant thermique.

Le dispositif comporte avantageusement un matériau piézoélectrique dans les première et deuxième cavités. Le ou les matériaux piézoélectriques peut ou peuvent être en contact avec la paroi destinée à être en contact de la source chaude et/ou de la source froide. Le ou les matériaux piézoélectriques est ou sont de préférence sous forme de membranes suspendues.

Le diamètre du canal primaire est par exemple égal ou inférieur à celui des gouttes de liquide.

Le volume de la première et/ou de la deuxième cavité peut être compris entre 1 et 10 fois le volume d'une goutte de liquide.

Par exemple, le fluide mis en oeuvre peut être l'eau ou un solvant, par exemple un hydrofluoroéther.

Le dispositif de récupération et de conversion d'énergie thermique en énergie électrique peut comporter une pluralité de cellules adjacentes réparties avec une densité variable en fonction de la densité locale du flux thermique émis par la source chaude.

La présente invention a également pour objet un système de récupération et de conversion d'énergie thermique en énergie électrique comportant un dispositif de récupération et de conversion d'énergie thermique en énergie électrique selon l'invention, dans lequel la température de la source chaude est telle que la paroi de la première cavité en contact avec celle-ci est au moins égale à la température d'ébullition dudit fluide. Par exemple, la source chaude est formée par dispositif électronique portable.

### BRÈVE DESCRIPTION DES DESSINS

La présente invention sera mieux comprise à l'aide de la description qui va suivre et des dessins en annexes sur lesquels :
- la figure 1 est une vue en coupe longitudinale schématique d'un exemple de réalisation d'un dispositif de récupération et de conversion selon un premier mode de réalisation,
- la figure 2 est une vue en coupe longitudinale schématique d'une variante du dispositif de la figure 1,
- la figure 3 est une vue en coupe longitudinale schématique d'un autre exemple de réalisation d'un dispositif selon la premier mode de réalisation,
- les figures 4A à 4C son des vues en coupe longitudinales schématiques de différents exemples de réalisation d'un dispositif de récupération et de conversion selon un deuxième mode de réalisation,
- les figures 5A à 5D sont des vues de dessus d'exemples de répartition de dispositifs de récupération selon l'invention,
- la figure 6 est une vue en coupe longitudinale d'un exemple de réalisation pratique d'un dispositif de récupération et de conversion selon l'invention,

### EXPOSÉ DÉTAILLÉ DE MODES DE RÉALISATION PARTICULIERS

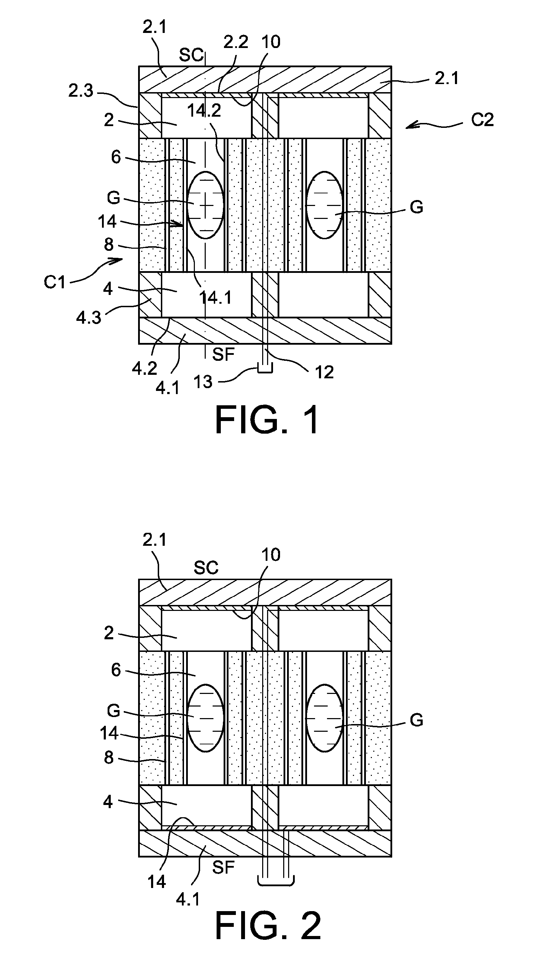

Sur la figure 1, on peut voir un exemple de réalisation d'un dispositif de récupération et de conversion comportant une première cavité 2, une deuxième cavité 4, un canal 6, dit canal primaire connectant la première cavité 2 et la deuxième cavité 4, et des deuxièmes canaux 8 , dits canaux secondaires, connectant la première cavité 2 et la deuxième cavité 4. Dans l'exemple représenté, le canal primaire s'étend suivant un axe longitudinal X. L'ensemble ainsi formé sera désigné par cellules. Le dispositif représenté sur la figure 1 comporte deux cellules C1 et C2.

La cavité 2 comporte une première et une deuxième paroi d'extrémité 2.1, 2.2 et des parois latérales 2.3. Dans l'exemple représenté, la première paroi d'extrémité 2.1 est destinée à être en contact avec une source chaude SC ; la paroi 2.1 sera désignée « paroi chaude » dans la suite de la description. La température atteinte par la paroi chaude 2.1 est telle qu'elle assure la vaporisation du fluide contenu dans le dispositif. Elle est donc au moins égale à la température d'ébullition du fluide. Des exemples de fluide seront donnés ci-dessous.

La source chaude SC peut par exemple être une face d'un composant électronique ou de toute autre source de chaleur.

La cavité 2 sera désignée dans la suite de la description « chambre » ou « chambre de vaporisation ».

La paroi d'extrémité 2.2 est traversée par le canal primaire 6.

De manière préférentielle, les parois de la cavité 2 sont en matériau bon conducteur thermique de sorte à assurer une répartition homogène de la température dans toute la cavité de vaporisation 2.

La deuxième cavité 4 comporte une première et une deuxième paroi d'extrémité 4.1, 4.2 et des parois latérales 4.3. Dans l'exemple, la paroi d'extrémité 4.1 comporte au moins une paroi 4.1 destinée à être en contact avec une source froide SF; la paroi 4.1 sera désignée « paroi froide » dans la suite de la description. La température de la paroi froide 4.1 est telle qu'elle assure la condensation de la vapeur formée dans la chambre de vaporisation 2. Elle est donc inférieure à la température d'ébullition du fluide.

La source froide SF est par exemple un radiateur à ailette ou directement l'air ambiant.

La cavité 4 sera désignée dans la suite de la description « chambre » ou « chambre de condensation ».

La deuxième paroi d'extrémité 4.2 est traversée par le canal primaire 6.

De manière préférentielle, les parois de la deuxième cavité sont également en matériau bon conducteur thermique de sorte à assurer une répartition homogène de la température dans toute la cavité de condensation 4.

En outre, la partie extérieure 9 du dispositif, disposée entre la chambre de vaporisation 2 et la chambre de condensation 4 et entourant le canal primaire 6 et les canaux secondaires 8, est formée en un matériau isolant thermique comme par exemple le verre pour éviter la conduction de la chaleur de la paroi chaude 2.1 vers la paroi froide 4.1.

Le dispositif comporte également au moins un élément apte à transformer une contrainte mécanique en énergie électrique. Dans l'exemple représenté, il s'agit d'une membrane en matériau piézoélectrique 10 disposée dans la cavité 2 contre la paroi chaude 2.1.

De manière avantageuse, la membrane 10 est suspendue par ses extrémités latérales. Une partie seulement de celle-ci est alors en contact avec la paroi chaude 2.1 de sorte à favoriser sa déformation macroscopique et donc augmenter la quantité d'énergie électrique générée.

La membrane piézoélectrique 10 est connectée à un système de collecte de l'énergie électrique, soit directement un système 13 consommant l'énergie produite, soit un système de stockage, tel qu'une batterie. Les connexions 12 et le système 13 sont représentés de manière schématique. Les connexions peuvent être réalisées par brasure avec un métal dont la température de fusion est inférieure à celle de fusion du matériau piézoélectrique. Les fils de connexion sortent à l'extérieur du dispositif via des canaux réalisés au travers de la partie extérieure en matériau isolant 9, des parois latérales 4.3 et de la paroi froide 4.1. Les connexions sont réalisées avant l'assemblage des parois chaude 2.1 et froide 4.1 avec la partie extérieure en matériau isolant 9.

En outre, le canal primaire 6 comporte une surface intérieure 14 telle qu'elle assure le déplacement de gouttes G de liquide de la cavité 4 vers la cavité 2. Dans l'exemple représenté, la surface intérieure 14 comporte des sections 14.1, 14.2, 14.3 présentant des propriétés de mouillabilité différentes, les sections étant réparties le long de l'axe X, de sorte à former une surface à gradient d'énergie de surface.

Les sections sont de plus en plus mouillantes en direction de la première cavité 2.

Une surface présente des propriétés de faible mouillabilité vis-à-vis d'un liquide, lorsque l'angle de contact θ d'une goutte dudit liquide est supérieur à 90°.

Dans le cas de l'eau, on parle de surface hydrophobe pour une surface faiblement mouillante, et de surface hydrophile pour une surface mouillante. Dans la suite de la description nous considérerons le cas de l'eau à des fins de simplicité, l'invention n'étant pas limitée à l'eau.

Les propriétés de mouillage peuvent être obtenues par le dépôt de matériaux présentant des affinités de mouillage différentes avec le fluide. On peut par exemple déposer du SiOx qui présente une faible mouillabilité par rapport à l'eau; l'angle de contact est compris entre 20° et 40° ou des fluorures de graphite (CFx) qui ont un caractère hydrophobe. On peut également modifier le niveau de mouillabilité par structuration, avantageusement par nanostructuration de la surface interne du canal primaire 6. En réalisant deux nanostructurations différentes, on peut réaliser deux sections ayant des mouillabilités différentes. La nanostructuration peut prendre la forme de cuvettes de taille nanométrique à micrométrique ménagées en surface du matériau.

La section de passage du canal primaire 6 est supérieure à celui des canaux secondaires 8, et est telle qu'elle permet la circulation de gouttes de liquide tandis que les canaux secondaires 8 sont destinés à ne permettre que le passage de la vapeur.

Dans le cas de l'eau, de préférence le diamètre du canal primaire est de l'ordre de la longueur capillaire, c'est-à-dire comprise entre 3 mm et 5 mm, avantageusement de l'ordre de 4 mm; de préférence, le diamètre du canal secondaire est de l'ordre de la longueur capillaire divisée par 10, c'est-à-dire le diamètre des canaux secondaires est par exemple inférieur à 0,4 mm.

Dans l'exemple représenté, le dispositif comporte plusieurs canaux secondaires 8. Par exemple, ils sont répartis tout autour du canal primaire. On peut envisager qu'il n'y ait qu'un canal secondaire qui présente une forme annulaire et entoure complètement le canal primaire.

Le fonctionnement du dispositif de récupération et de conversion de la figure 1 est le suivant : une goutte de fluide s'évapore brutalement dans la chambre de vaporisation 2 en entrant en contact avec la paroi chaude 2.1 qui se trouve à une température supérieure à la température d'ébullition du fluide. La brusque évaporation génère un pic de pression dans les chambres 2 et 4 et dans les canaux primaire 6 et secondaires 8 sous l'effet du confinement du gaz. Cette variation de pression déclenche une déformation de la membrane piézoélectrique 10, ce qui génère une tension/un courant électrique à ses bornes qui est transporté par les connexions 12 vers le système consommateur ou de stockage 13. Le fluide à l'état de gaz est quasi instantanément réparti dans le volume des chambres 2,4 et des canaux 6, 8 et se condense en une goutte de fluide dans la chambre 4 au contact de la paroi froide 4.1. La goutte condensée est alors soumise à deux forces : elle est d'une part attirée dans le canal primaire 6 de la chambre 4 vers la chambre 2 par la surface interne à gradient d'énergie de surface, ce gradient d'énergie créé par les caractéristiques physicochimiques de la paroi interne 14 du canal primaire 6 permet à la goutte de minimiser son énergie en se déplaçant le long du canal primaire 6.

D'autre part, elle est aussi poussée dans la même direction par la pression transmise de la chambre 2 qui s'échauffe vers la chambre 4 par les canaux secondaires 8 dont la taille est trop faible pour laisser passer une goutte mais suffisamment grande pour transmettre la pression. Les canaux secondaires 8 ont aussi pour fonction de ne pas laisser une sous-pression se générer dans la chambre 4 du fait du déplacement de la goutte. Ils permettent donc à la pression d'accompagner la goutte lors de son transfert de la chambre 4 vers la chambre 2. En arrivant dans cette dernière la goutte est à nouveau vaporisée brutalement et le cycle recommence.

La taille de la cellule et le volume de fluide sont par exemple tels qu'une seule goutte circule dans le canal puis se vaporise et se condense.

Le fonctionnement du dispositif conduit donc à des pics de pression qui sont cycliques, à partir d'une source chaude SC dont la température ne varie pas ou peu ou alors dont la température varie lentement. Ces pics de pression sont convertis en électricité par la membrane piézoélectrique 10.

Les signaux électriques sont disponibles sur les connexions de la membrane 10 et sont cycliques dans le temps. Ils peuvent donc être exploités par des circuits électroniques de récupération d'énergie et être traités pour être stockés et/ou utilisés.

Dans l'exemple de la figure 1, le dispositif comporte deux cellules distinctes C1 et C2, un dispositif avec une seule cellule ne sort pas néanmoins du cadre de la présente invention. Avantageusement, on prévoit un grand nombre de cellules juxtaposées de sorte à maximiser la quantité d'énergie électrique récupérée.

Les cellules peuvent êtres réparties uniformément ou non en réalisant par exemple des différences de densité pour ajuster localement et de façon contrôlable la densité de flux thermique passant au travers de cette structure.

Sur la figure 2, on peut voir une variante du dispositif de la figure 1, dans laquelle une membrane piézoélectrique 14 est également prévue dans la chambre de condensation 4. Comme pour la membrane 10, celle-ci est avantageusement suspendue par rapport à la paroi froide 4.1.

On pourrait prévoir une membrane piézoélectrique dans la chambre de condensation 4 uniquement.

Alternativement on pourrait prévoir des membranes piézoélectriques au niveau des parois latérales et/ou dans les canaux secondaires.

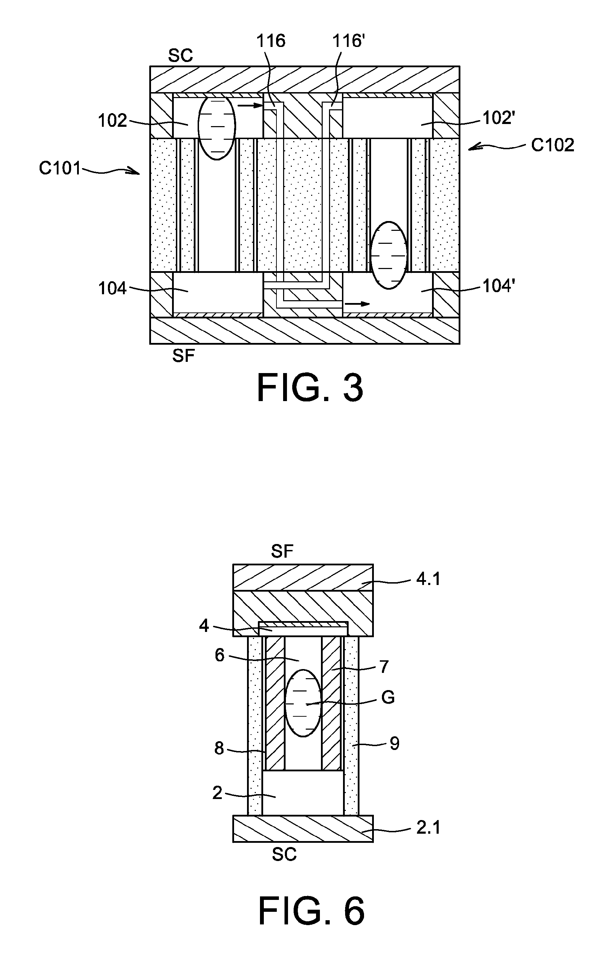

Sur la figure 3, on peut voir un autre exemple d'un dispositif dans lequel deux cellules sont interconnectées.

Chaque cellules C101, C102 sont similaires aux cellules C1 et C2 des figures 1 et 2. Le dispositif comporte cependant un canal 116 reliant la chambre 102 de la cellule C101 à la chambre de condensation 104' de la cellule C102 et un canal 116' reliant la chambre de vaporisation 102' de la cellule C102 à la chambre de condensation 104 de la cellule C101. Les canaux 116 et 116' sont destinés à transférer la pression générée dans les chambres de vaporisation 102, 102' vers la chambre de condensation 104', 104 de l'autre cellule.

Des canaux secondaires 108 connectent la chambre 102 et la chambre 104.

Dans cet exemple de réalisation, outre les forces exercées par les surfaces à gradient d'énergie de surface des canaux primaires, c'est la pression du gaz généré par la vaporisation d'une goutte dans la chambre de vaporisation 102 de la cellule C101 qui génère la force de déplacement de la goutte de la chambre de condensation 104' vers la chambre de vaporisation 102' de la cellule C102, et c'est la pression du gaz généré par la vaporisation d'une goutte dans la chambre de vaporisation 102', qui génère la force de déplacement de la goutte de la chambre de condensation 104 vers la chambre de vaporisation 102 de la cellule C101 comme montré sur la figure 3. Il y a donc un transfert de fluide d'une cellule à l'autre.

Dans cet exemple de réalisation, ce couplage provoque avantageusement un entraînement des cellules entre elles.

De manière alternative, les surfaces à gradient d'énergie de surface peuvent être remplacées par des surfaces présentant des effets de polarisation électrique, de type électromouillage. Pour cela un réseau d'électrodes est prévu dans la paroi des canaux primaires et sont activées progressivement pour déplacer la goutte.

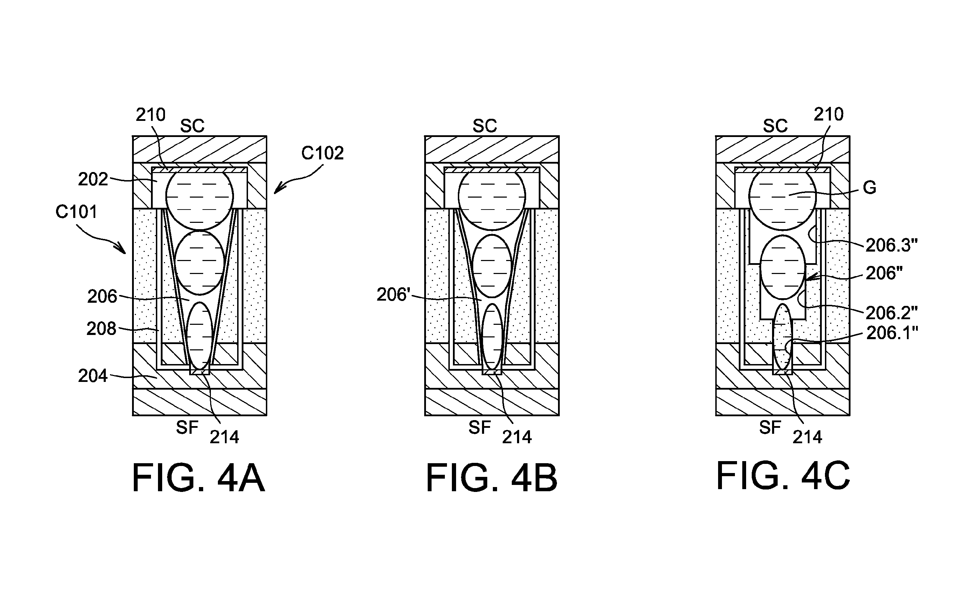

Sur les figures 4A à 4B, on peut voir des exemples d'un autre mode de réalisation, dans lequel la forme du canal primaire varie.

Le canal primaire 206 comporte une section de passage variable le long de l'axe X. Plus particulièrement il comporte une section de passage croissante le long de l'axe X de la chambre de condensation 204 vers la chambre de vaporisation 202. Une membrane piézoélectrique 210, 214 est disposée dans chaque chambre 202, 204. En outre, il présente une surface faiblement mouillante, ou hydrophobe dans le cas de l'eau. Des canaux secondaires 208 sont également prévus.

Sur la figure 4A, la paroi du canal primaire 206 présente une forme de cône tronqué.

Sur la figure 4B, le rayon du canal primaire 206' augmente de manière non linéaire le long de l'axe X de telle manière la surface intérieure du canal primaire présente un profil convexe.

Sur la figure 4C, le canal primaire 206" est composé de portions tubulaires 206.1", 206.2", 206.3" de section croissante, trois dans l'exemple représenté.

Une goutte de liquide progressant dans les canaux primaire est représentée sur chacune des trois figures 4A à 4C.

On pourrait prévoir de combiner par exemple les formes des figures 4A et 4C ou 4B et 4C. Les sections 206.1, 206.2, 206.3 ne seraient plus de rayon constant mais aurait une forme de cône ou une surface intérieure convexe. Toute autre forme facilitant le déplacement directionnel des gouttes de liquide est envisageable.

Dans un autre exemple de réalisation, le canal primaire des figures 4A à 4C peut présenter une surface à gradient d'énergie de surface et/ou à effet de polarisation électrique.

L'exemple de réalisation de la figure 3 dans lequel deux cellules C101, C102 sont couplés peut être mis en oeuvre avec les dispositifs des figures 4A à 4C.

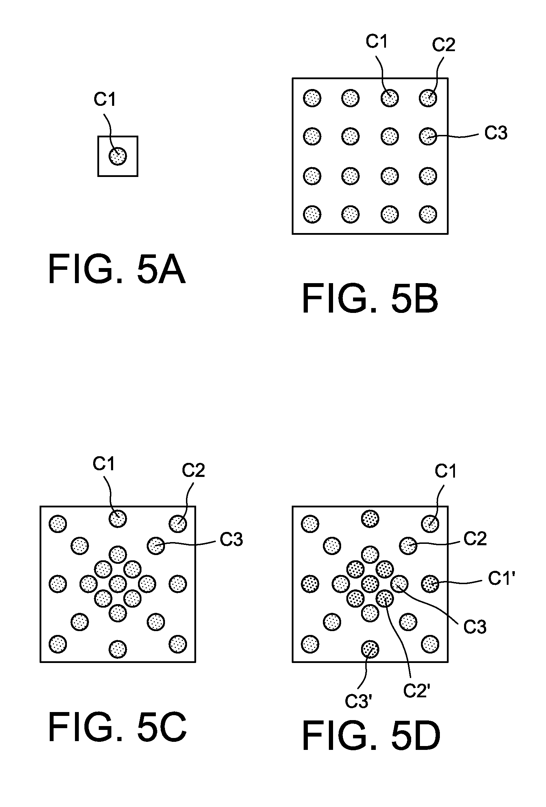

Comme expliqué ci-dessus avec la figure 5D, le dispositif peut comporter des cellules de différents types. Par exemple les cellules pourraient présenter de moyens différents pour déplacer la goutte suivant les cellules et la disposition.

Les dimensions du canal primaire et des chambres de vaporisation et d'ébullition sont choisies en fonction de la taille des gouttes. Le diamètre du canal primaire est de préférence égal ou inférieur à celui de la goutte pour que les effets de surface interviennent. Les chambres de vaporisation et d'ébullition ont de préférence un volume compris entre 1 et 10 fois le volume de goutte pour maximiser l'effet de confinement et l'amplitude des pics de pression.

Dans l'exemple représenté, les canaux peuvent être droits ou présenter des géométries plus complexes. En outre, la section des canaux peut être circulaire, elliptique, parallélépipédique ou tout autre.

Sur la figure 6, on peut voir un exemple de réalisation pratique d'un dispositif similaire à celui de la figure 1 muni d'une seule cellule.

Le dispositif comporte une paroi chaude 2.1 à une température comprise entre 110°C et 150°C, une surface froide 4.1 à une température comprise entre 50°C et 80°C, un tube en verre 9 reliant la paroi chaude 2.1 et la paroi froide 4.1.

Le canal primaire 6 est formé par un tube en acier inox. Un canal secondaire annulaire 8 est délimité entre le tube en acier inox 7 et le tube en verre 9, celui-ci présente une épaisseur de 0,5 mm. Le diamètre du canal primaire 6 est par exemple compris entre 1 mm et 4 mm.

La chambre de condensation 4 a une hauteur de l'ordre de 0,5 mm et un diamètre de l'ordre de 10 mm environ et une chambre de vaporisation 2 a un diamètre de 15 mm et une hauteur comprise entre 1 mm et 3 mm.

Par exemple, les sources de chaleur utilisables et offrant des températures de l'ordre de 110°C à 150°C sont par exemple les canalisations d'usine que l'on équipe de capteurs autonomes alimentés par le dispositif selon l'invention, ou des canalisations enterrées difficilement atteignables équipées de capteurs autonomes alimentés par le dispositif selon l'invention.

Sur les figures 5A à 5D, on peut voir des exemples de répartition de cellules. La répartition des cellules peut permettre d'optimiser la gestion thermique par exemple en évacuant un flux thermique plus important au centre du dispositif que sur les cotés. Sur la figure 5A, le dispositif comporte une seule cellule C1. Sur la figure 5B, le dispositif comportent une pluralité de cellules C1, C2, C3... réparties en matrice. Sur la figure 5C, les cellules sont réparties suivant un schéma en étoile à huit branches.

Sur la figure 5D, il s'agit de la même répartition que celle de la figure 5C mais avec deux types de cellules C1, C2, C3... et C1', C2', C3'... ayant des propriétés différentes de façon à ajuster leurs performances ou leurs domaines de fonctionnement et par exemple de pouvoir répondre à des domaines de températures différents en utilisant des fluides de températures d'ébullition différentes, par exemple, de l'eau et de l'éthanol. Les cellules peuvent aussi présenter des dimensions différentes.

Dans le cas de dispositifs de taille macroscopique, les différents éléments peuvent être réalisés par usinage ou toute autre technique adaptée.

Dans le cas de dispositif à l'échelle microscopique, on peut utiliser des techniques de microélectronique, telles que les dépôts de films isolants, de fils conducteurs, lithographies, par gravures ionique réactive (RIE pour "Reactive-ion Etching" en terminologie anglo-saxonne) etc. De plus les matériaux utilisés peuvent être autres que ceux utilisés dans la microélectronique, comme par exemple les céramiques isolantes, les polymères...

Les membranes piézoélectriques pourront être sous forme de membranes macroscopiques ou déposées sous forme de couches minces.

La surface de gradient d'énergie de surface pourra par exemple être obtenue par dépôt chimique en phase vapeur (CVD pour "Chemical Vapor Deposition") de matériaux à faible mouillabilité ou à bonne mouillabilité.

Par exemple, pour réaliser les différentes sections présentant des propriétés de mouillabilité différentes, on peut par exemple protéger une partie du canal primaire par un matériau sacrificiel comme une résine, de façon à déposer dans un deuxième temps le matériau à faible mouillabilité ou à bonne mouillabilité. La résine est ensuite retirée. Dans une deuxième étape, la première partie déposée pourra être à son tour protégée par une résine, de façon à déposer sur la deuxième partie du canal le matériau complémentaire à bonne mouillabilité ou à faible mouillabilité. Ainsi peuvent être réalisés des canaux présentant un gradient d'énergie de surface le long de leurs axes.

Dans le cas de gouttes de faible diamètre, par exemple inférieur au millimètre, une surface ainsi réalisée assure un meilleur contrôle du déplacement de la goutte.

A titre d'exemple, les matériaux mis en oeuvre peuvent être :
- pour les matériaux conducteurs thermiques, il peut s'agir d'un métal comme le cuivre, l'aluminium, etc. Il peut s'agir de matériaux anisotropes tels que le graphite, des nanocomposites comprenant des nanotubes de carbone,
- pour les matériaux isolants thermiques et électriques, on peut choisir un polymère, la silice ou une céramique isolante telle que la zircone ou l'alumine,
- pour réaliser la surface à gradient d'énergie de surface, les matériaux peuvent être le SiOx ou CFx, de surfaces nanostructurées.

Par exemple, la ou les membranes en matériau piézoélectrique peut ou peuvent être en PZT, PLZT, PMNT, PMNZ ou en PFW.

Enfin, le fluide mis en oeuvre peut être de l'eau, des solvants, des fluides utilisés dans les applications thermiques, des fluides chargés de particules ou des mélanges de ces fluides. Parmi les solvants préférés, on peut citer les hydrofluoroéthers.

Le dispositif selon l'invention permet grâce à l'utilisation de changement de phase, de récupérer et convertir de l'énergie thermique en électricité par un moyen permettant de générer des pics périodiques de pression et de tension/courant électrique propres à être utilisés efficacement par des circuits électroniques de récupération d'énergie.

Celui-ci permet, grâce à la mise en oeuvre de canaux primaires comportant des surfaces internes à gradient d'énergie de surface, des canaux primaires à géométries adaptées, ou des canaux à polarisation électrique adaptée, ou d'une combinaison de ses moyens, ainsi que des canaux secondaires, de générer une force de transfert des gouttes qui permet de miniaturiser les dispositifs vers des dimensions caractéristiques de canaux de l'ordre de 10 µm à plusieurs millimètres, et d'utiliser des dispositifs dans toutes les positions, y compris lorsque la source chaude se situe en dessous de la source froide ou lorsque l'axe est dans une position horizontale. Cette liberté d'orientation du dispositif est particulièrement intéressante dans le cas d'une source chaude formée par un dispositif solaire qui est situé dans une partie supérieure, ou de dispositifs mobiles ou d'électronique portable dont l'orientation peut varier au cours de l'utilisation.

De plus, le dispositif selon l'invention permet, grâce à des adaptations de densité de cellules, i.e. nombres de cellules par unité de surface, de contrôler les densités de flux thermiques transférés par ces architectures.

Le dispositif selon l'invention adapté à la récupération d'énergie thermique et à sa conversion en énergie électrique peut être utilisé pour l'alimentation de dispositifs électroniques basse consommation, par exemple des capteurs autonomes.

En outre, en utilisant des fluides ayant une température d'ébullition adaptée, des dispositifs fonctionnant à des températures différentes peuvent être fabriqués.

Par conséquent, outre le fait d'utiliser la chaleur pour produire de l'énergie thermique, ce dispositif a pour effet d'évacuer la chaleur, il joue alors simultanément à la génération d'électricité le rôle de système de refroidissement.

Le dispositif selon l'invention peut également être utilisé comme dispositif de gestion thermique en adaptant la quantité de liquide dans chaque cellule et le nombre de cellule et leur positionnement en fonction des températures des zones que l'on souhaite gérer thermiquement. Cette gestion peut être entièrement passive ou être au moins partiellement active dans le cas où l'on met en oeuvre l'électromouillage.

## Revendications

1. Dispositif de récupération et de conversion d'énergie thermique en énergie électrique comportant au moins une cellule (C1, C2, C101, C102) comprenant :
- une première cavité (2, 2') dont au moins une partie d'au moins une paroi (2.1) est destinée à être en contact avec une source de chaleur (SC),
- une deuxième cavité (4, 4') dont au moins une partie d'au moins une paroi (4.1) est destinée à être en contact avec une source froide (SF),
- un canal primaire (6) reliant la première cavité (2) et la deuxième cavité (4) destiné à transporter un fluide sous forme de gouttes liquides, le canal primaire comportant des moyens assurant le transport de gouttes de fluide liquide de la deuxième cavité (4) vers la première cavité (2),
- au moins un canal secondaire (8) reliant la première cavité (2) et la deuxième cavité (4) destiné à transporter le fluide sous forme de gaz,
- au moins un matériau piézoélectrique (10) disposé dans au moins l'une des première (2) et deuxième (4) cavités,
- un fluide sous forme liquide et gazeuse confiné dans la cellule,
- des moyens de connexion (12) dudit matériau piézoélectrique (10) à un dispositif de récupération de l'énergie électrique générée par le matériau piézoélectrique (10).

2. Dispositif de récupération et de conversion d'énergie thermique en énergie électrique selon la revendication 1, dans lequel les moyens assurant le transport de gouttes de fluide liquide sont formés par la surface interne du canal primaire présentant un gradient d'énergie de surface orientée de telle sorte que les gouttes de liquide se déplacent de la deuxième cavité (4, 4') vers la première cavité (2, 2').

3. Dispositif de récupération et de conversion d'énergie thermique en énergie électrique selon la revendication 2, dans lequel le gradient d'énergie de surface est obtenue par au moins une première et une deuxième sections de surface disposées successivement dans cet ordre entre la deuxième cavité et la première cavité, chacune desdites sections présentant des propriétés de mouillabilité vis-à-vis du fluide, la mouillabilité de la deuxième section étant supérieure à celle de la première section, les propriétés de mouillabilité étant avantageusement obtenues par une couche d'un matériau présentant lesdites propriétés de mouillabilité et/ou par structuration d'au moins une section de la surface interne.

4. Dispositif de récupération et de conversion d'énergie thermique en énergie électrique selon la revendication 1, dans lequel les moyens assurant le transport de gouttes de fluide liquide sont de type électrostatique, par exemple mettent en oeuvre le phénomène d'électromouillage.

5. Dispositif de récupération et de conversion d'énergie thermique en énergie électrique selon l'une des revendications 1 à 4, dans lequel le canal primaire (6) présente une section de passage croissante de la deuxième cavité (4, 4') vers la première cavité (2, 2'), avantageusement au moins une partie de la surface interne du canal primaire (6) du côté de la deuxième cavité (4, 4') présentant des propriétés de faible mouillabilité vis-à-vis du fluide.

6. Dispositif de récupération et de conversion d'énergie thermique en énergie électrique selon la revendication 5, dans lequel le canal primaire (6) présente une forme évasée ou dans lequel le canal primaire (6) comporte au moins deux tronçons successifs présentant des sections de passage différentes, les section de passage augmentant de la deuxième cavité (4) vers la première cavité (2).

7. Dispositif de récupération et de conversion d'énergie thermique en énergie électrique selon l'une des revendications 1 à 6, dans lequel la section de passage du canal secondaire (8) est telle qu'elle empêche le passage de gouttes liquides.

8. Dispositif de récupération et de conversion d'énergie thermique en énergie électrique selon l'une des revendications 1 à 7, dans lequel le canal secondaire (8) débouche dans la deuxième cavité (4) à proximité d'une extrémité du canal primaire (6) débouchant dans ladite deuxième cavité (2).

9. Dispositif de récupération et de conversion d'énergie thermique en énergie électrique selon l'une des revendications 1 à 8, comportant au moins une première (C101) et une deuxième (C102) cellules, et un canal de transfert (116) connectant la première cavité (102) de la première cellule (C101) à la deuxième cavité (104') de la deuxième cellule (C102) et la deuxième cavité (104) de la première cellule (C101) à la première cavité (102') de la deuxième cellule (C102).

10. Dispositif de récupération et de conversion d'énergie thermique en énergie électrique selon l'une des revendications 1 à 9, dans lequel les parois (2.1, 40.1) des première (2) et deuxième (4) cavités sont réalisées en un matériau bon conducteur thermique et dans lequel le dispositif comporte un élément extérieur (9) reliant les parois des première (2) et deuxième (4) cavités, ledit élément extérieur (9) étant en matériau isolant thermique.

11. Dispositif de récupération et de conversion d'énergie thermique en énergie électrique selon l'une des revendications 1 à 10, dans lequel le ou les matériaux piézoélectriques (10, 14), qui peuvent être dans l'une parmi la première (2) et la deuxième (4) cavités ou dans la première (2) et la deuxième cavité (4), est ou sont en contact de la paroi (2.1, 4.1) destinée à être en contact de la source chaude (SC) et/ou de la source froide (SF).

12. Dispositif de récupération et de conversion d'énergie thermique en énergie électrique selon l'une des revendications 1 à 11, dans lequel le ou les matériaux piézoélectriques (10, 14) est ou sont sous forme de membranes suspendues.

13. Dispositif de récupération et de conversion d'énergie thermique en énergie électrique selon l'une des revendications 1 à 12, dans lequel le diamètre du canal primaire (6) est égal ou inférieur à celui des gouttes de liquide.

14. Dispositif de récupération et de conversion d'énergie thermique en énergie électrique selon l'une des revendications 1 à 13, dans lequel le volume de la première (2) et/ou de la deuxième (4) cavité est compris entre 1 et 10 fois le volume d'un goutte de liquide.

15. Dispositif de récupération et de conversion d'énergie thermique en énergie électrique selon l'une des revendications 1 à 14, comportant une pluralité de cellules adjacentes (C1, C2), lesdites cellules (C1, C2) étant réparties avec une densité variable en fonction de la densité locale du flux thermique émis par la source chaude.

16. Système de récupération et de conversion d'énergie thermique en énergie électrique comportant un dispositif de récupération et de conversion d'énergie thermique en énergie électrique selon l'une des revendications 1 à 15, dans lequel la température de la source chaude (SC) est telle que la température de la paroi (2.1) de la première cavité (2) en contact avec celle-ci est au moins égale à la température d'ébullition dudit fluide, la source chaude (SC) étant avantageusement formée par dispositif électronique portable.

## Patentansprüche

1. Vorrichtung zur Rückgewinnung und Umwandlung von Wärmeenergie in elektrische Energie, die wenigstens eine Zelle (C1, C2, C101, C102) aufweist, umfassend:
- einen ersten Hohlraum (2, 2'), wobei wenigstens ein Teil wenigstens einer Wandung (2.1) dazu vorgesehen ist, mit einer Wärmequelle (SC) in Kontakt zu stehen,
- einen zweiten Hohlraum (4, 4'),wobei wenigstens ein Teil wenigstens einer Wandung (4.1) dazu vorgesehen ist, mit einer Kältequelle (SF) in Kontakt zu stehen,
- ein Primärkanal (6), der den ersten Hohlraum (2) und den zweiten Hohlraum (4) verbindet und dazu vorgesehen ist, ein Fluid in Form von flüssigen Fluidtropfen zu transportieren, wobei der Primärkanal Mittel umfasst, die den Transport der flüssigen Fluidtropfen von dem zweiten Hohlraum (4) zu dem ersten Hohlraum (2) gewährleisten,
- wenigstens einen Sekundärkanal (8), der den ersten Hohlraum (2) und den zweiten Hohlraum (4) verbindet und dazu vorgesehen ist, das Fluid in Gasform zu transportieren,
- wenigstens ein piezoelektrisches Material (10), das in wenigstens einem aus ersten (2) und zweitem (4) Hohlraum angeordnet ist,
- ein flüssiges und gasförmiges Fluid, das in der Zelle begrenzt ist,
- Verbindungsmittel (12) von dem piezoelektrischen Material (10) zu einer Vorrichtung zur Rückgewinnung der von dem piezoelektrischen Material (10) erzeugten elektrischen Energie.

2. Vorrichtung zur Rückgewinnung und Umwandlung von Wärmeenergie in elektrische Energie nach Anspruch 1, wobei die Mittel, die den Transport der flüssigen Fluidtropfen gewährleisten, durch die Innenfläche des Primärkanals gebildet sind, mit einem Oberflächenenergie-Gradienten, der derart ausgerichtet ist, dass sich die Flüssigkeitstropfen von dem zweiten Hohlraum (4, 4') zu dem ersten Hohlraum (2, 2') verlagern.

3. Vorrichtung zur Rückgewinnung und Umwandlung von Wärmeenergie in elektrische Energie nach Anspruch 2, wobei der Oberflächenenergie-Gradient durch wenigstens einen ersten und einen zweiten Oberflächenabschnitt erhalten wird, die aufeinanderfolgend in dieser Reihenfolge zwischen dem zweiten Hohlraum und dem ersten Hohlraum angeordnet sind, wobei jeder der Abschnitte Benetzbarkeitseigenschaften gegenüber dem Fluid aufweist, wobei die Benetzbarkeit des zweiten Abschnitts größer ist als jene des ersten Abschnitts, wobei die Benetzbarkeitseigenschaften vorteilhafterweise durch eine Schicht eines Materials erzielt werden, das die genannten Benetzbarkeitseigenschaften aufweist und/oder durch Strukturierung wenigstens eines Abschnitts der Innenfläche.

4. Vorrichtung zur Rückgewinnung und Umwandlung von Wärmeenergie in elektrische Energie nach Anspruch 1, wobei die Mittel, die den Transport der flüssigen Fluidtropfen gewährleisten, vom elektrostatischen Typ sind, und beispielsweise das Phänomen der Elektrobenetzung umsetzen.

5. Vorrichtung zur Rückgewinnung und Umwandlung von Wärmeenergie in elektrische Energie nach einem der Ansprüche 1 bis 4, wobei der Primärkanal (6) einen zunehmenden Durchlassquerschnitt des zweiten Hohlraums (4, 4') zu dem ersten Hohlraum (2, 2') aufweist, wobei vorteilhafterweise wenigstens ein Teil der Innenfläche des Primärkanals (6) auf der Seite des zweiten Hohlraums (4, 4') Eigenschaften einer schwachen Benetzbarkeit gegenüber dem Fluid aufweist.

6. Vorrichtung zur Rückgewinnung und Umwandlung von Wärmeenergie in elektrische Energie gemäß Anspruch 5, wobei der Primärkanal (6) eine auskragende Form aufweist, oder wobei der Primärkanal (6) wenigstens zwei aufeinanderfolgende Abschnitte umfasst, die unterschiedliche Durchlassquerschnitte aufweisen, wobei die Durchlassquerschnitte von dem zweiten Hohlraum (4) zu dem ersten Hohlraum (2) zunehmen.

7. Vorrichtung zur Rückgewinnung und Umwandlung von Wärmeenergie in elektrische Energie nach einem der Ansprüche 1 bis 6, wobei der Durchlassquerschnitt des Sekundärkanals (8) derart ist, dass er den Durchlass von Flüssigkeitstropfen verhindert.

8. Vorrichtung zur Rückgewinnung und Umwandlung von Wärmeenergie in elektrische Energie nach einem der Ansprüche 1 bis 7, wobei der Sekundärkanal (8) in den zweiten Hohlraum (4) in der Nähe eines Endes des Primärkanals (6) mündet, der wiederum in den zweiten Hohlraum (2) mündet.

9. Vorrichtung zur Rückgewinnung und Umwandlung von Wärmeenergie in elektrische Energie nach einem der Ansprüche 1 bis 8, welche wenigstens eine erste (C101) und eine zweite (C102) Zelle aufweist, und einen Transferkanal (116), der den ersten Hohlraum (102) der ersten Zelle (C101) mit dem zweiten Hohlraum (104') der zweiten Zelle (C102) sowie den zweiten Hohlraum (104) der ersten Zelle (C101) mit dem ersten Hohlraum (102') der zweiten Zelle (C102) verbindet.

10. Vorrichtung zur Rückgewinnung und Umwandlung von Wärmeenergie in elektrische Energie nach einem der Ansprüche 1 bis 9, wobei die Wandungen (2.1, 40.1) des ersten (2) und des zweiten (4) Hohlraums aus einem Material mit guten Wärmeleiteigenschaften gebildet sind und wobei die Vorrichtung ein äußeres Element (9) umfasst, das die Wandungen des ersten (2) und des zweiten (4) Hohlraums verbindet, wobei das äußere Element (9) aus einem wärmeisolierenden Material gebildet ist.

11. Vorrichtung zur Rückgewinnung und Umwandlung von Wärmeenergie in elektrische Energie nach einem der Ansprüche 1 bis 10, wobei das piezoelektrische Material oder die piezoelektrischen Materialien (10, 14), die in einem aus erstem (2) und zweitem (4) Hohlraum oder in dem ersten (2) und dem zweiten Hohlraum(4) vorliegen können, in Kontakt mit der Wandung (2.1, 4.1) ist/sind, welche dazu vorgesehen ist, in Kontakt mit der Wärmequelle (SC) und/oder der Kältequelle (SF) zu stehen.

12. Vorrichtung zur Rückgewinnung und Umwandlung von Wärmeenergie in elektrische Energie nach einem der Ansprüche 1 bis 11, wobei das piezoelektrische Material oder die piezoelektrischen Materialien (10, 14) in der Form schwebender Membranen vorliegt/vorliegen.

13. Vorrichtung zur Rückgewinnung und Umwandlung von Wärmeenergie in elektrische Energie nach einem der Ansprüche 1 bis 12, wobei der Durchmesser des Primärkanals (6) denjenigen der Flüssigkeitstropfen entspricht oder kleiner ist.

14. Vorrichtung zur Rückgewinnung und Umwandlung von Wärmeenergie in elektrische Energie nach einem der Ansprüche 1 bis 13, wobei das Volumen des ersten (2) und/oder des zweiten (4) Hohlraums zwischen dem Ein- und Zehnfachen des Volumens eines Flüssigkeitstropfens liegt.

15. Vorrichtung zur Rückgewinnung und Umwandlung von Wärmeenergie in elektrische Energie nach einem der Ansprüche 1 bis 14, welche eine Mehrzahl von benachbarten Zellen (C1, C2) aufweist, wobei die Zellen (C1, C2) mit einer variablen Dichte abhängig von der örtlichen Dichte des von der Wärmequelle ausgegebenen Wärmeflusses verteilt sind.

16. Vorrichtung zur Rückgewinnung und Umwandlung von Wärmeenergie in elektrische Energie nach einem der Ansprüche 1 bis 15, wobei die Temperatur der Wärmequelle (SC) derart ist, dass die Temperatur der Wandung (2.1) des ersten Hohlraums (2) in Kontakt mit dieser Wärmquelle wenigstens gleich der Siedetemperatur des Fluids ist, wobei die Wärmequelle (SC) vorteilhafterweise durch eine tragbare elektronische Vorrichtung gebildet ist.

## Claims

1. A device for recovering and converting heat energy into electrical energy comprising at least one cell (C1, C2, C101, C102) comprising:
- a first cavity (2, 2') at least one part of at least one wall (2.1) of which is configured to contact a heat source (HS),
- a second cavity (4, 4') at least one part of at least one wall (4.1) of which is configured to contact a cold source (CS),
- a primary channel (6) connecting the first cavity (2) and the second cavity (4) intended to transport a fluid as liquid drops, the primary channel comprising means providing transport of liquid fluid drops from the second cavity (4) to the first cavity (2),
- at least one secondary channel (8) connecting the first cavity (2) and the second cavity (4) intended to transport the fluid as a gas,
- at least one piezoelectric material (10) provided in at least one of the first (2) and second (4) cavities,
- a fluid as a liquid and gas contained within the cell,
- means (12) for connecting said piezoelectric material (10) to a device for recovering electrical energy generated by the piezoelectric material (10).

2. The device for recovering and converting heat energy into electrical energy according to claim 1, wherein the means providing transport of liquid fluid drops are formed by the inner surface of the primary channel having a surface energy gradient oriented such that the liquid drops move from the second cavity (4, 4') to the first cavity (2, 2').

3. The device for recovering and converting heat energy into electrical energy according to claim 2, wherein the surface energy gradient is obtained by at least a first and a second surface portions successively arranged in this order between the second cavity and the first cavity, each of said portions having fluid-wettability properties, the wettability of the second portion being higher than that of the first portion, the wettability properties being advantageously obtained by a layer of a material having said wettability properties and/or by structuring at least one portion of the inner surface.

4. The device for recovering and converting heat energy into electrical energy according to claim 1, wherein the means providing transport of liquid fluid drops are of the electrostatic type, for example implement the electro-wetting phenomenon.

5. The device for recovering and converting heat energy into electrical energy according to one of claims 1 to 4, wherein the primary channel (6) has a flow cross section raising from the second cavity (4, 4') to the first cavity (2, 2'), advantageously at least one part of the inner surface of the primary channel (6) on the side of the second cavity (4, 4') has low fluid-wettability properties.

6. The device for recovering and converting heat energy into electrical energy according to claim 5, wherein the primary channel (6) has a flared shape or the primary channel (6) comprises least two successive segments having different flow cross sections, the flow cross sections increasing from the second cavity (4) to the first cavity (2).

7. The device for recovering and converting heat energy into electrical energy according to one of claims 1 to 6, wherein the flow cross section of the secondary channel (8) is such that it prevents liquid drops from flowing through.

8. The device for recovering and converting heat energy into electrical energy according to one of claims 1 to 7, wherein the secondary channel (8) opens into the second cavity (4) in the proximity of one end of the primary channel (6) opening into said second cavity (2).

9. The device for recovering and converting heat energy into electrical energy according to one of claims 1 to 8, comprising at least a first (C101) and a second (C102) cells, and a transfer channel (116) connecting the first cavity (102) of the first cell (C101) to the second cavity (104') of the second cell (C102) and the second cavity (104) of the first cell (C101) to the first cavity (102') of the second cell (C102).

10. The device for recovering and converting heat energy into electrical energy according to one of claims 1 to 9, wherein the walls (2.1, 40.1) of the first (2) and second (4) cavities are made of a good heat conducting material and wherein the device comprises an external element (9) connecting the walls of the first (2) and second (4) cavities, said external element (9) being of a heat insulating material.

11. The device for recovering and converting heat energy into electrical energy according to one of claims 1 to 10, wherein the piezoelectric material (s) (10, 14) that can be in one of the first (2) and second (4) cavities or in the first (2) and second (4) cavities, is (are) contacting the wall (2.1, 4.1) configured to contact the hot source (HS) and/or cold source (CS).

12. The device for recovering and converting heat energy into electrical energy according to one of claims 1 to 11, the piezoelectric material(s) (10, 14) is (are) as suspended membranes.

13. The device for recovering and converting heat energy into electrical energy according to one of claims 1 to 12, wherein the diameter of the primary channel (6) is lower than or equal to that of the liquid drops.

14. The device for recovering and converting heat energy into electrical energy according to one of claims 1 to 13, wherein the volume of the first (2) and/or second (4) cavity is between 1 and 10 times the volume of a liquid drop.

15. The device for recovering and converting heat energy into electrical energy according to one of claims 1 to 14, comprising a plurality of adjacent cells (C1, C2), said cells (C1, C2) being distributed with a variable density as a function of the local density of the heat flux emitted by the hot source.

16. A system for recovering and converting heat energy into electrical energy comprising a device for recovering and converting heat energy into electrical energy according to one of claims 1 to 15, wherein the temperature of the heat source (HS) is such that the temperature of the wall (2.1) of the first cavity (2) contacting the same is at least equal to the boiling temperature of said fluid, the hot source (HS) being advantageously formed by a portable electronic device.
